(19) Europäisches Patentamt
European Patent Office
Office européen des brevets

(11) EP 2 006 891 A1

(12) **EUROPEAN PATENT APPLICATION**
published in accordance with Art. 153(4) EPC

(43) Date of publication:
**24.12.2008 Bulletin 2008/52**

(21) Application number: **07739939.2**

(22) Date of filing: **27.03.2007**

(51) Int Cl.:
***H01L 21/304*** *(2006.01)* ***B24B 37/00*** *(2006.01)*
***C09K 3/14*** *(2006.01)*

(86) International application number:
**PCT/JP2007/056501**

(87) International publication number:
**WO 2007/116770 (18.10.2007 Gazette 2007/42)**

(84) Designated Contracting States:
**DE FR IT**

(30) Priority: **03.04.2006 JP 2006102203**

(71) Applicant: **JSR Corporation**
**Tokyo 104-8410 (JP)**

(72) Inventors:
- **TAKEMURA, Akihiro**
  **Chuo-ku, Tokyo 104-8410 (JP)**
- **SHIDA, Hirotaka**
  **Chuo-ku, Tokyo 104-8410 (JP)**
- **IKEDA, Masatoshi**
  **Chuo-ku, Tokyo 104-8410 (JP)**

(74) Representative: **TBK-Patent**
**Bavariaring 4-6**
**80336 München (DE)**

(54) **AQUEOUS DISPERSION FOR CHEMICAL MECHANICAL POLISHING, CHEMICAL MECHANICAL POLISHING METHOD, AND KIT FOR PREPARING AQUEOUS DISPERSION FOR CHEMICAL MECHANICAL POLISHING**

(57) A chemical mechanical polishing aqueous dispersion comprises (A) abrasive grains, (B) an organic acid, (C) a water-soluble polymer, (D) an oxidizing agent, and (E) water, the water-soluble polymer (C) having a weight average molecular weight of 50,000 to 5,000,000.

FIG. 3D

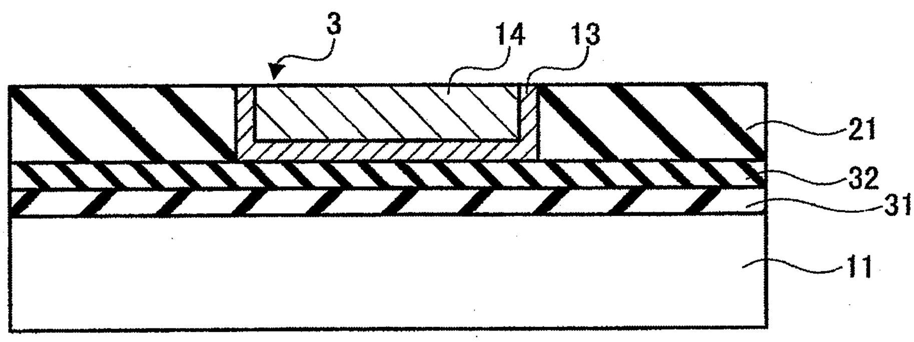


EP 2 006 891 A1

## Description

### TECHNICAL FIELD

The present invention relates to a chemical mechanical polishing aqueous dispersion, a chemical mechanical polishing method, and a kit for preparing the chemical mechanical polishing aqueous dispersion.

### BACKGROUND ART

In recent years, (i) a reduction in interconnect resistivity and (ii) a reduction in dielectric constant of an insulating layer have been desired to improve the performance of semiconductor devices, for example.

In order to achieve (i) a reduction in interconnect resistivity, copper or a copper alloy has been used as the interconnect material instead of tungsten and aluminum. However, it is difficult to process copper or a copper alloy by dry etching which has been used to form an interconnect layer using aluminum or the like. Therefore, when forming an interconnect using copper or a copper alloy, a damascene process in which copper or a copper alloy is deposited in a groove formed in an insulating layer, and unnecessary portions other than the interconnect are removed by chemical mechanical polishing has been used (see JP-A-2-278822, for example). When using copper or a copper alloy as the interconnect material, a conductive barrier layer is generally formed at the interface between the interconnect and the insulating material using tantalum, tantalum nitride, titanium nitride, or the like in order to prevent migration of copper atoms into the insulating material.

In order to achieve (ii) a reduction in dielectric constant of an insulating layer, various novel materials have been proposed. For example, JP-A-2001-308089 discloses a method that applies a hydrolysis-condensation product of an alkoxysilane on a substrate, and heats the applied product to obtain a low-dielectric-constant insulating layer. JP-A-2001-298023 discloses a method that subjects a silane gas containing an organosilane compound to chemical vapor deposition under enhanced conditions due to plasma or microwaves to obtain a low-dielectric-constant insulating layer.

When using such a low-dielectric-constant insulating layer, a silicon oxide film material (cap layer) is generally stacked on the low-dielectric-constant insulating layer in order to protect the low-dielectric-constant insulating layer from gas absorption or metal atom diffusion from the interconnect material. In this case, the insulating layer is a laminate of the low-dielectric-constant insulating layer and the silicon oxide film material.

When producing a semiconductor device in which copper or a copper alloy is used as the interconnect material while utilizing a low-dielectric-constant insulating layer, a step of removing the interconnect material on the conductive barrier layer by chemical mechanical polishing (first polishing step) and a step of removing the conductive barrier layer by polishing, and optionally polishing the interconnect material and the insulating layer to achieve planarization (second polishing step) are normally carried out. The following problem occurs when carrying out the second polishing step.

Specifically, since the low-dielectric-constant insulating layer has a low strength and low adhesion to another material (e.g., cap layer), when chemical mechanical polishing is performed using a known chemical mechanical polishing aqueous dispersion, the material may be damaged or delamination may occur at the interface with another material, whereby the yield decreases to a large extent. This problem may be dealt with by reducing a frictional force applied to a wafer by reducing the polishing pressure, for example.

However, the polishing rate of the silicon oxide film material including the cap layer decreases as a result of reducing the polishing pressure. In the device production process, since it is necessary to ensure flatness by removing the cap layer by polishing or removing the cap layer with a specific thickness by polishing, the semiconductor substrate process efficiency decreases to a large extent due to a decrease in the polishing rate of the silicon oxide film material.

### DISCLOSURE OF THE INVENTION

The invention was conceived in view of the above-described situation. An object of the invention is to provide a chemical mechanical polishing aqueous dispersion that enables a polishing target to be polished with high efficiency and a polished surface with excellent flatness to be efficiently obtained, a chemical mechanical polishing method using the chemical mechanical polishing aqueous dispersion, and a kit for preparing the chemical mechanical polishing aqueous dispersion.

As a result of extensive studies, the inventors of the present invention found that the polishing rate can be significantly increased and a polished surface with excellent flatness can be efficiently obtained without causing scratches and film separation by performing chemical mechanical polishing using a chemical mechanical polishing aqueous dispersion that contains a water-soluble polymer having specific properties.

The inventors also found that the above chemical mechanical polishing aqueous dispersion that contains a water-soluble polymer having specific properties can ensure a practical polishing rate even at a low polishing pressure that aims to prevent scratches and film separation.

As a result of extensive studies, the inventors of the present invention found that the polishing rate can be significantly increased and a polished surface with excellent flatness can be efficiently obtained without causing scratches and film separation by performing chemical mechanical polishing using a chemical mechanical polishing aqueous dispersion that contains a water-soluble polymer having specific properties.

The inventors also found that the above chemical mechanical polishing aqueous dispersion that contains a water-soluble polymer having specific properties can ensure a practical polishing rate even at a low polishing pressure that aims to prevent scratches and film separation.

A first aspect of the invention provides a chemical mechanical polishing aqueous dispersion comprising (A) abrasive grains, (B) an organic acid, (C) a water-soluble polymer, (D) an oxidizing agent, and (E) water, the water-soluble polymer (C) having a weight average molecular weight of 50,000 to 5,000,000.

In the above chemical mechanical polishing aqueous dispersion, the water-soluble polymer (C) may be poly (meth)acrylic acid or its salt.

The above chemical mechanical polishing aqueous dispersion may contain the water-soluble polymer (C) in an amount of 0.05 to 2 wt%.

The above chemical mechanical polishing aqueous dispersion may have a pH of 8 to 12.

In the above chemical mechanical polishing aqueous dispersion, the organic acid (B) may be at least one organic acid selected from the group consisting of quinolinecarboxylic acid, a divalent organic acid, and a hydroxyl acid, and the chemical mechanical polishing aqueous dispersion may contain the organic acid (B) in an amount of 0.01 to 5 mass%.

In the above chemical mechanical polishing aqueous dispersion, the ratio of the amount of the water-soluble polymer (C) to the amount of the organic acid (B) may be 1:40 to 20:1.

The above chemical mechanical polishing aqueous dispersion may further comprise (F) a surfactant in an amount of 0.001 to 1 mass%. In this case, the ratio of the amount of the water-soluble polymer (C) to the amount of the surfactant (F) may be 1:10 to 200:1. In this case, the surfactant (F) may be a nonionic surfactant.

The above chemical mechanical polishing aqueous dispersion may contain the abrasive grains (A) in an amount of 1 to 10 mass%.

In the above chemical mechanical polishing aqueous dispersion, the abrasive grains (A) may be silica.

A second aspect of the invention provides a kit for preparing the above chemical mechanical polishing aqueous dispersion by mixing a liquid (I) and a liquid (II),
the liquid (I) being an aqueous dispersion including (A) abrasive grains, (B) an organic acid, (C) a water-soluble polymer having a weight average molecular weight of 50,000 to 5,000,000, and (E) water; and
the liquid (II) including (D) an oxidizing agent and (E) water.

A third aspect of the invention provides a kit for preparing the above chemical mechanical polishing aqueous dispersion by mixing a liquid (I) and a liquid (II),
the liquid (I) being an aqueous dispersion including (A) abrasive grains and (E) water; and
the liquid (II) including (B) an organic acid, (C) a water-soluble polymer having a weight average molecular weight of 50,000 to 5,000,000, and (E) water.

A fourth aspect of the invention provides a kit for preparing the above chemical mechanical polishing aqueous dispersion by mixing a liquid (I), a liquid (II), and a liquid (III),
the liquid (I) being an aqueous dispersion including (A) abrasive grains and (E) water;
the liquid (II) including (B) an organic acid, (C) a water-soluble polymer having a weight average molecular weight of 50,000 to 5,000,000, and (E) water; and
the liquid (III) including (D) an oxidizing agent and (E) water.

In the above kit, the liquid (I) may further comprise one or more components selected from (B) an organic acid, (C) a water-soluble polymer having a weight average molecular weight of 50,000 to 5,000,000, (D) an oxidizing agent, and (F) a surfactant.

In the above kit, the liquid (II) may further comprise one or more components selected from (A) abrasive grains, (D) an oxidizing agent, and (F) a surfactant.

A fifth aspect of the invention provides a method of producing a chemical mechanical polishing aqueous dispersion comprising chemically and mechanically polishing a polishing target at a polishing pressure of 60 to 200 $gf/cm^2$ using the above-described chemical mechanical polishing aqueous dispersion.

Since the above chemical mechanical polishing aqueous dispersion has an appropriate viscosity due to the water-soluble polymer having a weight average molecular weight of 50,000 to 5,000,000, the polishing pressure can be efficiently transmitted to the polishing target. Therefore, a practical polishing rate can be maintained when polishing the polishing target at a low polishing pressure in order to reduce defects such as scratches and film separation. Moreover, since polishing friction decreases due to the hydrophilization effect of the water-soluble polymer, scratches and film separation can be suppressed.

According to the chemical mechanical polishing method using the above chemical mechanical polishing aqueous dispersion and the kit for preparing the above chemical mechanical polishing aqueous dispersion, various polishing targets can be efficiently polished with high efficiency to obtain a sufficiently planarized and accurately finished surface. Moreover, various polishing targets can be polished with sufficient efficiency even at a low polishing pressure.

BRIEF DESCRIPTION OF THE DRAWINGS

FIG. 1A is a schematic view showing a specific example of a chemical mechanical polishing method according to the invention.
FIG. 1B is a schematic view showing a specific example of a chemical mechanical polishing method according to the invention.
FIG. 1C is a schematic view showing a specific example of a chemical mechanical polishing method according to the invention.
FIG. 2A is a schematic view showing a specific example of a chemical mechanical polishing method according to the invention.
FIG. 2B is a schematic view showing a specific example of a chemical mechanical polishing method according to the invention.
FIG. 2C is a schematic view showing a specific example of a chemical mechanical polishing method according to the invention.
FIG. 2D is a schematic view showing a specific example of a chemical mechanical polishing method according to the invention.
FIG. 3A is a schematic view showing another specific example of a chemical mechanical polishing method according to the invention.
FIG. 3B is a schematic view showing the other specific example of a chemical mechanical polishing method according to the invention.
FIG. 3C is a schematic view showing the other specific example of a chemical mechanical polishing method according to the invention.
FIG. 3D is a schematic view showing the other specific example of a chemical mechanical polishing method according to the invention.

BEST MODE FOR CARRYING OUT THE INVENTION

Embodiments of the invention are described below with reference to the drawings. Note that the invention is not limited to the following embodiments. The invention includes various modifications within the spirit and scope of the invention.

1. Chemical mechanical polishing aqueous dispersion

A chemical mechanical polishing aqueous dispersion according to one embodiment of the invention comprises (A) abrasive grains, (B) an organic acid, (C) a water-soluble polymer, (D) an oxidizing agent, and (E) water, the water-soluble polymer (C) having a weight average molecular weight of 50,000 to 5,000,000.

1.1. Abrasive grains (A)

The abrasive grains (A) may be at least one type of abrasive grains selected from inorganic particles, organic particles, and organic-inorganic composite particles.
Examples of the inorganic particles include silica, alumina, titania, zirconia, ceria, and the like. Examples of the silica include fumed silica, silica synthesized by a sol-gel method, colloidal silica, and the like. The fumed silica may be obtained by reacting silicon chloride or the like with oxygen and water in a gaseous phase. The silica synthesized by the sol-gel method may be obtained by hydrolysis and/or condensation of an alkoxysilicon compound as a raw material. The colloidal silica may be obtained by an inorganic colloid method using a raw material purified in advance, for example.
Examples of the organic particles include polyvinyl chloride, a styrene (co)polymer, polyacetal, polyester, polyamide, polycarbonate, an olefin (co)polymer, a phenoxy resin, an acrylic (co)polymer, and the like. Examples of the olefin (co)polymer include polyethylene, polypropylene, poly-1-butene, poly-4-methyl-1-pentene, and the like. Examples of the acrylic (co)polymer include polymethyl methacrylate and the like.
The type and the configuration of the organic-inorganic composite particles are not particularly limited insofar as inorganic particles and organic particles as mentioned above are integrally formed in such a manner that the inorganic

particles and the organic particles are not easily separated during a chemical mechanical polishing step. The organic-inorganic composite particles may have one of the following configurations (i) to (iii), for example.

(i) Organic-inorganic composite particles obtained by polycondensation of an alkoxide compound of a metal or silicon in the presence of organic particles. Examples of the alkoxide compound of a metal or silicon include an alkoxysilane, an aluminum alkoxide, a titanium alkoxide, and the like. The resulting polycondensate may be bonded to a functional group of the organic particle either directly or through an appropriate coupling agent (e.g., silane coupling agent).

(ii) Organic-inorganic composite particles in which organic particles and inorganic particles having zeta potentials of opposite polarities (positive or negative) are bonded due to an electrostatic force. In this case, the composite particles may be formed by mixing the organic particles and the inorganic particles in a pH region in which the organic particles and the inorganic particles have zeta potentials of opposite polarities, or may be formed by mixing the organic particles and the inorganic particles in a pH region in which the organic particles and the inorganic particles have zeta potentials of an identical polarity, and then changing the liquid property to a pH region in which the organic particles and the inorganic particles have zeta potentials of opposite polarities.

(iii) Organic-inorganic composite particles obtained by polycondensation of an alkoxide compound of a metal or silicon in the presence of the composite particles (ii). As the alkoxide compound of a metal or silicon, the alkoxide compound mentioned for the organic-inorganic composite particles (i) may be used.

The abrasive grains (A) are preferably at least one type of abrasive grains selected from silica, the organic particles, and the organic-inorganic composite particles mentioned above, with silica being particularly preferable.

The average particle diameter of the abrasive grains (A) is preferably 5 to 500 nm, more preferably 20 to 200 nm, and still more preferably 50 to 150 nm. An appropriate polishing rate and an excellent polished surface can be achieved using the abrasive grains (A) having an average particle diameter within this range.

The abrasive grains (A) are used in an amount of 1 to 10 mass%, and preferably 2 to 5 mass% based on the total amount of the chemical mechanical polishing aqueous dispersion according to one embodiment of the invention. If the amount of the abrasive grains (A) is more than 10 mass % , the polishing rate can be increased. However, cost inevitably increases. If the amount of the abrasive grains (A) is less than 1 mass%, the throughput of semiconductor production decreases due to a decrease in polishing rate.

1.2. Organic acid (B)

As the organic acid (B), an organic acid having four or more carbon atoms is preferable. As the organic acid having four or more carbon atoms, an aliphatic organic acid having four or more carbon atoms and an organic acid having a heterocyclic ring are preferable.

Examples of the aliphatic organic acid having four or more carbon atoms include an aliphatic polycarboxylic acid having four or more carbon atoms, a hydroxyl acid having four or more carbon atoms, and the like. Specific examples of the aliphatic polycarboxylic acid having four or more carbon atoms include a divalent organic acid such as maleic acid, succinic acid, fumaric acid, glutaric acid, and adipic acid. Specific examples of the hydroxyl acid having four or more carbon atoms include citric acid, malic acid, tartaric acid, and the like.

Examples of the organic acid having a heterocyclic ring include quinolinecarboxylic acid, pyridinecarboxylic acid, pyridinedicarboxylic acid, pyrazinecarboxylic acid, and the like.

Among these, quinaldic acid (e.g., 2-quinolinecarboxylic acid), quinolinic acid (e.g., 2,3-pyridinedicarboxylic acid), a divalent organic acid (e.g., maleic acid or malonic acid), and a hydroxyl acid (e.g., malic acid or citric acid) are preferable as the organic acid (B), with quinolinecarboxylic acid, a divalent organic acid, and a hydroxyl acid being more preferable.

It is preferable to use two or more organic acids (B) in combination. When two or more organic acids (B) are used in combination, copper, a conductive barrier layer, and an insulating layer can be polished at polishing rates that do not differ to a large extent, whereby a polished surface with excellent flatness can be obtained.

The organic acid (B) is preferably used in an amount of 0.01 to 5 mass%, and more preferably 0.05 to 2 mass% based on the total amount of the chemical mechanical polishing aqueous dispersion according to one embodiment of the invention. An appropriate polishing rate and an excellent polished surface can be achieved using the organic acid (B) in an amount within this range. In particular, when the organic acid (B) is at least one organic acid selected from the group consisting of quinolinecarboxylic acid, a divalent organic acid, and a hydroxyl acid, and the chemical mechanical polishing aqueous dispersion contains the organic acid (B) in an amount of 0.01 to 5 mass% based on the total amount of the chemical mechanical polishing aqueous dispersion, an appropriate polishing rate and an excellent polished surface

can be achieved more reliably.

1.3. Water-soluble polymer (C)

Examples of the water-soluble polymer (C) include a thermoplastic resin such as polyacrylic acid and its salt, polymethacrylic acid and its salt, polyvinyl alcohol, polyvinylpyrrolidone, and polyacrylamide. It is preferable to use polyacrylic acid or polymethacrylic acid since the stability of the abrasive grains is not affected. It is more preferable to use polyacrylic acid in order to efficiently provide viscosity to the chemical mechanical polishing aqueous dispersion according to one embodiment of the invention.
The weight average molecular weight of the water-soluble polymer (C) is preferably 50,000 to 5,000,000, and more preferably 500,000 to 2,500,000. If the weight average molecular weight of the water-soluble polymer (C) is less than 50,000, the effect of providing the aqueous dispersion with viscosity is small, whereby the polishing rate is increased to only a small extent. If the weight average molecular weight of the water-soluble polymer (C) is 5,000,000 or more, the stability of the aqueous dispersion may deteriorate, or the viscosity of the aqueous dispersion may increase to a large extent, thereby imposing a load on a polishing liquid supply device, for example.
The water-soluble polymer (C) is preferably used in an amount of 0.05 to 2 mass % , more preferably 0.075 to 1 mass % , and still more preferably 0.1 to 0.5 mass%. The resulting aqueous dispersion exhibits an appropriate viscosity by incorporating the water-soluble polymer (C) in an amount within this range. If the amount of the water-soluble polymer (C) is less than 0.05 mass%, the effect of providing the aqueous dispersion with viscosity is small. As a result, a practical polishing rate may not be maintained at a low polishing pressure. Moreover, since the effect of reducing polishing friction deteriorates, scratches and defects may not be suppressed. If the amount of the water-soluble polymer (C) is more than 2 mass%, the thickness of a film of the water-soluble polymer (C) formed on the polishing target surface increases, whereby the polishing rate decreases. Moreover, the viscosity of the aqueous dispersion may increase to a large extent, thereby imposing a load on a polishing liquid supply device.
The ratio of the amount of the water-soluble polymer (C) to the amount of the organic acid (B) is preferably 1: 40 to 20:1, and more preferably 1:20 to 1:1. If the ratio of the amount of the water-soluble polymer (C) to the amount of the organic acid (B) is within this range, an appropriate polishing rate and an excellent polished surface can be achieved more reliably.

1.4. Oxidizing agent (D)

Examples of the oxidizing agent (D) include a persulfate, hydrogen peroxide, an inorganic acid, an organic peroxide, a polyvalent metal salt, and the like. Examples of the persulfate include ammonium persulfate, potassium persulfate, and the like. Examples of the inorganic acid include nitric acid, sulfuric acid, and the like. Examples of the organic peroxide include peracetic acid, perbenzoic acid, tert-butyl hydroperoxide, and the like.
Examples of the polyvalent metal salt include a permanganic acid compound, a dichromic acid compound, and the like. Examples of the permanganic acid compound include potassium permanganate and the like. Examples of the dichromic acid compound include potassium dichromate and the like. Among these, hydrogen peroxide, the persulfate, and the inorganic acid are preferable, with hydrogen peroxide being particularly preferable from the viewpoint of purity and handling capability.
The oxidizing agent (D) is preferably used in an amount of 0.01 to 5 mass%, and more preferably 0.05 to 2 mass% based on the total amount of the chemical mechanical polishing aqueous dispersion according to one embodiment of the invention. An appropriate polishing rate and an excellent polished surface can be achieved by incorporating the oxidizing agent (D) in an amount within this range.
When using hydrogen peroxide as the oxidizing agent (D) in the chemical mechanical polishing aqueous dispersion according to one embodiment of the invention, an appropriate polyvalent metal ion (e.g., iron sulfate hydrate) which promotes the function of hydrogen peroxide as the oxidizing agent and increases the polishing rate may be added to the chemical mechanical polishing aqueous dispersion.

1.5. Water (E)

It is preferable that the chemical mechanical polishing aqueous dispersion according to one embodiment of the invention include the water (E) as an aqueous medium. The chemical mechanical polishing aqueous dispersion according to one embodiment of the invention may include an alcohol or an organic solvent miscible with water in addition to the water (E).

1.6. Surfactant (F)

The chemical mechanical polishing aqueous dispersion according to one embodiment of the invention may further include a surfactant.

Examples of the surfactant include a cationic surfactant, an anionic surfactant, an ampholytic surfactant, a nonionic surfactant, and the like. It is preferable to use the anionic surfactant or the nonionic surfactant, with the nonionic surfactant being more preferable.

Examples of the anionic surfactant include a carboxylate, a sulfonate, a sulfate salt, a phosphate salt, and the like. Examples of the carboxylate include a fatty acid soap, an alkyl ether carboxylate, and the like. Examples of the sulfonate include an alkylbenzenesulfonate, an alkylnaphthalenesulfonate, an alpha-olefin sulfonate, and the like. Examples of the sulfate salt include a higher alcohol sulfate salt, an alkyl ether sulfate, a polyoxyethylene alkyl phenyl ether sulfate, and the like. Examples of the phosphate salt include an alkyl phosphate salt and the like.

Examples of the nonionic surfactant include a polyethylene glycol type surfactant, an acetylene glycol, an ethylene oxide adduct of an acetylene glycol, an acetylene alcohol, and the like.

The nonionic surfactant is preferably a compound having a triple bond in the molecule. Examples of such a compound include an acetylene glycol, an ethylene oxide adduct of an acetylene glycol, an acetylene alcohol, and the like. The hydrophilic-lipophilic balance of the nonionic surfactant having a triple bond in terms of an HLB value is preferably 3 to 20, and particularly preferably 5 to 20.

Examples of commercially available products of the nonionic surfactant having a triple bond are given below. Examples of the acetylene glycol include Surfynol 82 (HLB value=5 to 7) and Surfynol 104 (HLB value=3 to 5) (manufactured by Air Products Japan, Inc.). Examples of the ethylene oxide adduct of an acetylene glycol include Surfynol 440 (HLB value=8), Surfynol 465 (HLB value=13), and Surfynol 485 (HLB value= 17) (manufactured by Air Products Japan, Inc.). Examples of the acetylene alcohol include Surfynol 61 (HLB value=4 to 6) (manufactured by Air Products Japan, Inc.).

It is particularly preferable to use a nonionic surfactant shown by the following structural formula (1).

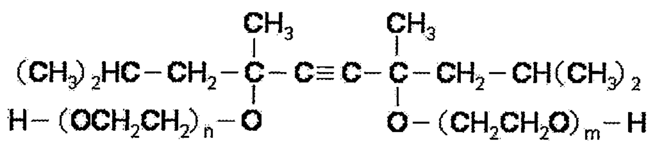

(1)

wherein n and m individually represent integers equal to or larger than one, provided that n+m≤50 is satisfied.

Use of the nonionic surfactant shown by the formula (1) enables a highly accurate and highly planarized polished surface to be obtained without impairing the physical properties of an insulating layer. In the formula (1), it is preferable that n+m be 10≤n+m≤50, and more preferably 20≤n+m≤40.

The surfactant (C) is preferably used in an amount of 0.001 to 1 mass%, and more preferably 0.005 to 0.5 mass% based on the total amount of the chemical mechanical polishing aqueous dispersion according to one embodiment of the invention. An appropriate polishing rate and an excellent polished surface can be achieved by incorporating the surfactant (C) in an amount within this range.

The ratio of the amount of the water-soluble polymer (C) to the amount of the surfactant (F) is preferably 1:10 to 200:1, and more preferably 1:5 to 10:1. If the ratio of the amount of the water-soluble polymer (C) to the amount of the surfactant (F) is within this range, an appropriate polishing rate and an excellent polished surface can be achieved more reliably.

1.7. Other components

The chemical mechanical polishing aqueous dispersion according to one embodiment of the invention may optionally include an additive such as an anti-corrosion agent. Examples of the anti-corrosion agent include benzotriazole and benzotriazole derivatives.

1.8. pH of chemical mechanical polishing aqueous dispersion

The chemical mechanical polishing aqueous dispersion according to one embodiment of the invention may be used in a pH region of higher than 3. The pH of the chemical mechanical polishing aqueous dispersion is preferably 8

to 12, and more preferably 9 to 11. An appropriate polishing rate and an excellent polished surface can be achieved by adjusting the pH of the chemical mechanical polishing aqueous dispersion to this range. In particular, when the pH of the chemical mechanical polishing aqueous dispersion according to one embodiment of the invention is 8 to 12 (more preferably 9 to 11), the water-soluble polymer (C) can stably exist on the polishing target surface, whereby the polishing rate can be further increased.

The pH of the chemical mechanical polishing aqueous dispersion according to one embodiment of the invention may be adjusted using a pH adjusting agent. Examples of the pH adjusting agent include an organic base, an inorganic base, and an inorganic acid. Examples of the organic base include tetramethylammonium hydroxide, triethylamine, and the like. Examples of the inorganic base include ammonia, potassium hydroxide, sodium hydroxide, and the like. Examples of the inorganic acid include nitric acid, sulfuric acid, and the like. A salt with a pH buffer effect such as ammonium carbonate or ammonium hydrogencarbonate may be appropriately used in combination with the pH adjusting agent.

1.9. Kit for preparing chemical mechanical polishing aqueous dispersion

The chemical mechanical polishing aqueous dispersion according to one embodiment of the invention of the invention may be supplied in a state in which the chemical mechanical polishing aqueous dispersion can be directly used as a polishing composition after the preparation. Alternatively, a polishing composition containing each component of the chemical mechanical polishing aqueous dispersion according to one embodiment of the invention at a high concentration (i.e., concentrated polishing composition) may be provided, and the concentrated polishing composition may be diluted before use to obtain a desired chemical mechanical polishing aqueous dispersion.

For example, the chemical mechanical polishing aqueous dispersion according to one embodiment of the invention may be separately provided as a plurality of liquids (e.g., two or three liquids), and the liquids may be mixed before use. For example, the chemical mechanical polishing aqueous dispersion according to one embodiment of the invention may be prepared by mixing a plurality of liquids using first to third kits given below.

1.9.1. First kit

A first kit is a kit for preparing the chemical mechanical polishing aqueous dispersion according to one embodiment of the invention by mixing a liquid (I) and a liquid (II). In the first kit, the liquid (I) is an aqueous dispersion including the abrasive grains (A), the organic acid (B), the water-soluble polymer (C) having a weight average molecular weight of 50,000 to 5,000,000 and the water (E), and the liquid (II) includes the oxidizing agent (D) and the water (E). The liquid (I) or the liquid (II) may further include the surfactant (F).

When preparing the liquid (I) and the liquid (II) of the first kit, it is necessary to determine the concentration of each component in the liquid (I) and the liquid (II) so that each component is included in an aqueous dispersion obtained by mixing the liquid (I) and the liquid (II) in the above-mentioned concentration range. Each of the liquid (I) and the liquid (II) may contain each component at a high concentration (i.e. may be concentrated). In this case, the liquid (I) and the liquid (II) may be diluted before use. According to the first kit, the storage stability of the oxidizing agent can be improved by separately providing the liquid (I) and the liquid (II).

When preparing the chemical mechanical polishing aqueous dispersion according to one embodiment of the invention using the first kit, it suffices that the liquid (I) and the liquid (II) be separately provided (supplied) and integrally mixed at the time of polishing. The mixing method and the mixing timing are not particularly limited.

For example, the liquid (I) and the liquid (II) may be separately supplied to a polishing system and be mixed on a platen. Alternatively, the liquid (I) and the liquid (II) may be mixed before being supplied to the polishing system, or may be mixed in the polishing system when supplied through a line, or may be mixed in a mixing tank additionally provided. A line mixer or the like may be used to obtain a more uniform aqueous dispersion.

1.9.2. Second kit

A second kit is a kit for preparing the chemical mechanical polishing aqueous dispersion according to one embodiment of the invention by mixing a liquid (I) and a liquid (II). In the second kit, the liquid (I) is an aqueous dispersion including the abrasive grains (A) and the water (E), and the liquid (II) includes the organic acid (B), the water-soluble polymer (C) having a weight average molecular weight of 50,000 to 5,000,000, and the water (E).

When preparing the liquid (I) and the liquid (II) of the second kit, it is necessary to determine the concentration of each component in the liquid (I) and the liquid (II) so that each component is included in an aqueous dispersion obtained by mixing the liquid (I) and the liquid (II) in the above-mentioned concentration range. Each of the liquid (I) and the liquid (II) may contain each component at a high concentration (i.e. may be concentrated). In this case, the liquid (I) and the liquid (II) may be diluted before use. According to the second kit, the storage stability of the aqueous dispersion can be improved by separately providing the liquid (I) and the liquid (II).

When preparing the chemical mechanical polishing aqueous dispersion according to one embodiment of the invention using the second kit, it suffices that the liquid (I) and the liquid (II) be separately provided (supplied) and integrally mixed at the time of polishing. The mixing method and the mixing timing are not particularly limited.

For example, the liquid (I) and the liquid (II) may be separately supplied to a polishing system and be mixed on a platen. Alternatively, the liquid (I) and the liquid (II) may be mixed before being supplied to the polishing system, or may be mixed in the polishing system when supplied through a line, or may be mixed in a mixing tank additionally provided. A line mixer or the like may be used to obtain a more uniform aqueous dispersion.

1.9.3. Third kit

A third kit is a kit for preparing the chemical mechanical polishing aqueous dispersion according to one embodiment of the invention by mixing a liquid (I), a liquid (II), and a liquid (III). In the third kit, the liquid (I) is an aqueous dispersion including the abrasive grains (A) and the water (F), the liquid (II) includes the organic acid (B), the water-soluble polymer (C) having a weight average molecular weight of 50,000 to 5,000,000, and the water (E), and the liquid (III) includes the oxidizing agent (D) and the water (E).

When preparing the liquid (I), the liquid (II), and the liquid (III) of the third kit, it is necessary to determine the concentration of each component in the liquid (I), the liquid (II), and the liquid (III) so that each component is included in an aqueous dispersion obtained by mixing the liquid (I), the liquid (II), and the liquid (III) in the above-mentioned concentration range. Each of the liquid (I), the liquid (II), and the liquid (III) may contain each component at a high concentration (i.e. may be concentrated). In this case, the liquid (I), the liquid (II), and the liquid (III) may be diluted before use. According to the third kit, the storage stability of the aqueous dispersion can be improved by separately providing the liquid (I), the liquid (II), and the liquid (III).

When preparing the chemical mechanical polishing aqueous dispersion according to one embodiment of the invention using the third kit, it suffices that the liquid (I), the liquid (II), and the liquid (III) be separately provided (supplied) and be integrally mixed at the time of polishing. The mixing method and the mixing timing are not particularly limited.

For example, the liquid (I), the liquid (II), and the liquid (III) may be separately supplied to a polishing system and mixed on a platen. Or, the liquid (I), the liquid (II), and the liquid (III) may be mixed before being supplied to the polishing system, or may be mixed in the polishing system when supplied through a line, or may be mixed in a mixing tank additionally provided. A line mixer or the like may be used to obtain a more uniform aqueous dispersion.

In the second kit or the third kit, the liquid (I) may further include one or more components selected from the organic acid (B), the water-soluble polymer (C) having a weight average molecular weight of 50,000 to 5,000,000, the oxidizing agent (D), and the surfactant (F), and the liquid (II) may further include one or more components selected from the abrasive grains (A), the organic acid (B), and the surfactant (F).

1.10. Application

The chemical mechanical polishing aqueous dispersion according to one embodiment of the invention may be suitably used for chemical mechanical polishing of a polishing target (e.g., semiconductor device). Specifically, since the chemical mechanical polishing aqueous dispersion according to one embodiment of the invention has an appropriate viscosity due to the water-soluble polymer having specific properties, various polishing targets (e.g., each layer of a semiconductor device) can be efficiently subjected to chemical mechanical polishing at a polishing pressure lower than a normal polishing pressure. Moreover, a sufficiently planarized and accurately finished surface can be obtained.

More specifically, the chemical mechanical polishing aqueous dispersion according to one embodiment of the invention may be suitably used as a second chemical mechanical polishing aqueous dispersion in a second polishing step of a two-stage polishing process for forming a copper damascene interconnect, for example. Specifically, when subjecting a semiconductor device including an interconnect, a conductive barrier layer, and an insulating layer to chemical mechanical polishing in the second polishing step at a low polishing pressure, a polishing rate necessary for the interconnect, the conductive barrier layer, and the insulating layer (particularly a silicon oxide film material) can be obtained, and a polished surface with excellent flatness can be efficiently obtained.

2. Chemical mechanical polishing method

As examples of a polishing target subjected to a chemical mechanical polishing method according to one embodiment of the invention, composite substrate materials 1a, 2a, and 3a having structures shown in FIGS. 1A, 2A, and 3A can be given. The composite substrate materials 1a, 2a, and 3a include a substrate 11 formed of silicon or the like, an insulating film 12, a wiring depression 20 formed in the insulating film 12, a conductive barrier layer 13 formed to cover the insulating film 12 and the bottom and the inner wall of the depression 20, and a metal layer 14 formed over the conductive barrier layer 13 so that the wiring depression 20 is filled therewith.

The insulating layer 12 may be a single layer (see FIG. 1A). In this case, the insulating layer 12 may be a high-dielectric-constant insulating layer formed of PETEOS or the like. The insulating layer 12 may have a stacked structure including two or more layers (see FIGS. 2A and 3A). In this case, the insulating layer 12 may be a laminate of a first insulating layer 21 and a second insulating layer 22, for example. The first insulating film 21 is a low-dielectric-constant insulating layer (e.g., "Black Diamond" manufactured by Applied Materials), for example. The second insulating film 22 is a high-dielectric-constant insulating layer (e.g., PETEOS) having a dielectric constant higher than that of the first insulating layer 21. The second insulating film 22 may be formed by CVD using tetraethoxysilane, for example.

The conductive barrier layer 13 is formed of a high-melting-point metal or a high-melting-point metal compound such as tantalum, titanium, tantalum nitride, or titanium nitride. The metal layer 14 is formed of a metal interconnect material such as copper or a copper alloy.

The polishing target subjected to a chemical mechanical polishing method according to one embodiment of the invention may be the composite substrate material 3a shown in FIG 3A. For example, the composite substrate material 3a may include a third insulating film 31 formed of silicon oxide or the like, and a fourth insulating film 32 provided on the third insulating film 31 and formed of silicon nitride or the like, the third insulating film 31 and the fourth insulating film 32 being provided between the substrate 11 and the insulating film 12.

In the chemical mechanical polishing method according to one embodiment of the invention, the composite substrate material 1a may be polished according to the following process, for example. In the first polishing step, the metal layer 14 is chemically and mechanically polished using a first chemical mechanical polishing aqueous dispersion until the conductive barrier layer 13 is exposed (see FIG 1B). In the second polishing step, chemical mechanical polishing is performed using the chemical mechanical polishing aqueous dispersion according to one embodiment of the invention to remove the conductive barrier layer 13 in an area other than the bottom and the inner wall of the interconnect depression 20. A highly planarized damascene wiring structure 1 is thus obtained (see FIG 1C).

In the chemical mechanical polishing method according to one embodiment of the invention, the composite substrate material 2a or 3a may be polished according to the following process, for example. In the first polishing step, the metal layer 14 is chemically and mechanically polished using a first chemical mechanical polishing aqueous dispersion until the conductive barrier layer 13 is exposed (see FIGS. 2B and 3B). In the second polishing step, chemical mechanical polishing is performed using the chemical mechanical polishing aqueous dispersion according to one embodiment of the invention to remove the conductive barrier layer 13 in an area other than the bottom and the inner wall of the interconnect depression 20. In this case, the surface of the second insulating layer 22 is also polished and removed to obtain a highly planarized damascene wiring structure 2 or 3 (see FIGS. 2C, 2D, 3C, and 3D).

As the first polishing aqueous dispersion, a mixture obtained by mixing CMS7401, CMS7452 (manufactured by JSR Corporation), ion-exchanged water, and a 4 wt% ammonium persulfate aqueous solution in a weight ratio of 1: 1:2:4 may be suitably used.

The polishing process using the chemical mechanical polishing method according to one embodiment of the invention may be performed under known polishing conditions using a commercially available chemical mechanical polishing system (e.g., "LGP510" or "LGP552" manufactured by Lapmaster SFT Corporation, "EPO-112" or "EPO-222" manufactured by Ebara Corporation, "Mirra" manufactured by Applied Materials, Inc., or "AVANTI-472" manufactured by IPEC).

Preferable polishing conditions are appropriately set depending on the chemical mechanical polishing system used. For example, when using "EPO-112" as the chemical mechanical polishing system, the first polishing step and the second polishing step may be carried out under the following conditions.

Platen rotational speed: preferably 30 to 120 rpm, and more preferably 40 to 100 rpm Head rotational speed: preferably 30 to 120 rpm, and more preferably 40 to 100 rpm Ratio of platen rotational speed/head rotational speed: preferably 0.5 to 2, and more preferably 0.7 to 1.5

Polishing pressure: preferably 60 to 200 g/cm$^2$, and more preferably 100 to 150 g/cm$^2$ Chemical mechanical polishing aqueous dispersion supply rate: preferably 50 to 300 ml/min, and more preferably 100 to 200 ml/min

## 3. Examples

The invention is described below by way of examples. Note that the invention is not limited to the following examples.

### 3.1. Preparation of aqueous dispersion containing inorganic particles

#### 3.1.1. Preparation of aqueous dispersion containing fumed silica particles

2 kg of fumed silica particles ("Aerosil #90" manufactured by Nippon Aerosil Co., Ltd., average primary particle diameter: 20 nm) were dispersed in 6.7 kg of ion-exchanged water using an ultrasonic mixer. The mixture was filtered

through a filter having a pore diameter of 5 micrometers to obtain an aqueous dispersion containing the fumed silica particles. The average secondary particle diameter of the fumed silica contained in the aqueous dispersion was 220 nm.

3.1.2. Preparation of aqueous dispersion containing colloidal silica particles

3.1.2-1. Preparation of aqueous dispersion containing colloidal silica particles C1

A flask was charged with 70 parts by mass of 25 mass% aqueous ammonia, 40 parts by mass of ion-exchanged water, 170 parts by mass of ethanol, and 20 parts by mass of tetraethoxysilane. The mixture was heated to 60°C with stirring at a rotational speed of 180 rpm. After stirring the mixture at 60°C for two hours, the mixture was cooled to room temperature. An alcohol dispersion of colloidal silica particles was thus obtained.

The alcohol was removed from the dispersion at 80°C using a rotary evaporator while adding ion-exchanged water. This operation was repeated several times. An aqueous dispersion containing 20 wt% of colloidal silica particles C1 was prepared in this manner.

The average primary particle diameter, the average secondary particle diameter, and the average degree of association of the colloidal silica particles C 1 contained in the aqueous dispersion were respectively 25 nm, 40 nm, and 1.6.

3.1.2-2. Preparation of aqueous dispersion containing colloidal silica particles C2 or C3

An aqueous dispersion containing colloidal silica C2 or C3 was prepared in the same manner as in "3.1.2-1. Preparation of aqueous dispersion containing colloidal silica particles C1", except for changing the amounts of 25 mass% aqueous ammonia, ethanol, and tetraethoxysilane as shown in Table 1.

TABLE 1

| Colloidal silica | Amount of raw material | | | Colloidal silica content in aqueous dispersion (mass%) | Average primary particle diameter (nm) | Average secondary particle diameter (nm) | Degree of association |
|---|---|---|---|---|---|---|---|
| | Aqueous ammonia (concentration: 25 mass%) (parts by mass) | Ethanol (parts by mass) | Tetraethoxysilane (parts by mass) | | | | |
| C1 | 70 | 170 | 20 | 20.0 | 25 | 40 | 1.6 |
| C 2 | 65 | 175 | 25 | 20.0 | 35 | 70 | 2.0 |
| C 3 | 55 | 195 | 40 | 20.0 | 70 | 200 | 2.9 |

3.2. Preparation of aqueous dispersion containing organic-inorganic composite particles

3.2.1. Preparation of aqueous dispersion containing surface-treated organic particles

A flask was charged with 90 parts by mass of methyl methacrylate, 5 parts by mass of methoxy polyethylene glycol methacrylate ("NK Ester M-90G #400" manufactured by Shin-Nakamura Chemical Co., Ltd.), 5 parts by mass of 4-vinylpyridine, 2 parts by mass of an azo initiator ("V50" manufactured by Wako Pure Chemical Industries, Ltd.), and 400 parts by mass of ion-exchanged water. The mixture was heated to 70°C with stirring in a nitrogen gas atmosphere. The mixture was then stirred at 70°C for six hours. The reaction mixture was diluted with ion-exchanged water to obtain an aqueous dispersion containing 10 mass% of polymethyl methacrylate particles having a functional group containing a cation of an amino group and a polyethylene glycol chain and having an average particle diameter of 150 nm. The polymerization yield was 95%.

A flask was charged with 100 parts by mass of the resulting aqueous dispersion. After the addition of 1 part by mass of methyltrimethoxysilane, the mixture was stirred at 40°C for two hours. The pH of the mixture was adjusted to 2.0 by adding a 1N nitric acid aqueous solution to obtain an aqueous dispersion containing surface-treated organic particles. The zeta potential of the surface-treated organic particles contained in the aqueous dispersion was + 17 mV.

3.2.2. Preparation of aqueous dispersion containing inorganic particles (colloidal silica particles)

Colloidal silica particles ("Snowtex O" manufactured by Nissan Chemical Industries, Ltd., average primary particle diameter: 12 nm) were dispersed in water. The pH of the mixture was adjusted using a 1N potassium hydroxide aqueous solution to obtain an aqueous dispersion containing 10 mass% of colloidal silica particles and having a pH of 8.0.

The zeta potential of the colloidal silica particles contained in the aqueous dispersion was -40 mV.

3.2.3. Preparation of aqueous dispersion containing organic-inorganic composite particles

50 parts by mass of the aqueous dispersion prepared in "3.2.2. Preparation of aqueous dispersion containing inorganic particles (colloidal silica particles)" was slowly added to 100 parts by mass of the aqueous dispersion prepared in "3.2.1. Preparation of aqueous dispersion containing surface-treated organic particles" over two hours with stirring. The mixture was then stirred for two hours to obtain an aqueous dispersion containing particles in which the silica particles adhered to the polymethyl methacrylate particles.

After the addition of 2 parts by mass of vinyltriethoxysilane to the resulting aqueous dispersion, the mixture was stirred for one hour. Then, 1 part by mass of tetraethoxysilane was added to the mixture. After stirring the mixture at 60°C for three hours, the mixture was cooled to room temperature to prepare an aqueous dispersion containing 10 mass% of organic-inorganic composite particles having an average particle diameter of 180 nm.

The organic-inorganic composite particles contained in the aqueous dispersion were observed using a scanning electron microscope. As a result, it was found that the silica particles adhered to 80% of the surface of each polymethyl methacrylate particle.

3.3. Preparation of aqueous solution containing water-soluble polymer (C)

3.3.1. Preparation of aqueous solution containing polyacrylate P1

A vessel (internal volume: two liters) was charged with 1000 g of ion-exchanged water and 1 g of a 5 mass% ammonium persulfate aqueous solution. 500 g of a 20 mass% acrylic acid aqueous solution was then evenly added dropwise to the mixture over eight hours under reflux with stirring. After the addition, the mixture was allowed to stand for two hours under reflux to obtain an aqueous solution containing polyacrylic acid having a weight average molecular weight (Mw) of 1,100,000.

The aqueous solution was neutralized by slowly adding a 10 mass% potassium hydroxide aqueous solution to prepare an aqueous solution (pH: 7.5) containing 10 mass% of a polyacrylate P1 (potassium polyacrylate having a weight average molecular weight (Mw) of 1,100,000).

In the examples, the weight average molecular weight (PEG-reduced molecular weight) and the molecular weight distribution were measured by gel permeation chromatography (instrument: LC module-1 manufactured by Waters, detector: 410 differential refractometer manufactured by Waters). As a column, TSK alpha-M manufactured by Tosoh Corp. was used. A mixture of 0.1M NaCl aqueous solution/acetonitrile (=80/20) was used as an eluent.

3.3.2. Preparation of aqueous solution containing polyacrylate P2, P3, or P4

An aqueous solution (pH: 7.5) containing 10 mass% of a polyacrylate P2, P3, or P4 (potassium polyacrylate) was prepared in the same manner as in "3.3.1. Preparation of aqueous solution containing polyacrylate P1", except for changing the amount of ammonium persulfate as shown in Table 2. When producing the polyacrylates P2 to P4, sodium hydroxide or ammonia was used as a neutralizer for polyacrylic acid instead of the potassium hydroxide aqueous solution.

TABLE 2

| | Polyacrylic acid | | | |
|---|---|---|---|---|
| | P1 | P2 | P3 | P4 |
| Amount of ammonium persulfate (g) | 0.05 | 0.1 | 0.25 | 0.5 |
| Neutralizer | Potassium hydroxide | Potassium hydroxide | Ammonia | Potassium hydroxide |
| Weight average molecular weight | 1,100,000 | 380,000 | 65,000 | 12,000 |

3.3.3. Preparation of aqueous solution containing polyvinylpyrrolidone

As polyvinylpyrrolidone, an aqueous solution (solid content: 20%) of "K60" (manufactured by BASF, weight average molecular weight: about 350,000) was used.

3.4. Example 1

3.4.1. Preparation of second polishing aqueous dispersion (chemical mechanical polishing aqueous dispersion according to the invention)

A polyethylene bottle was charged with the aqueous dispersion containing the colloidal silica C2 prepared in "3.1.2-2. Preparation of aqueous dispersion containing colloidal silica particles C2 or C3" in such an amount that the amount of silica was 2 mass % . After the addition of 1 mass% of malonic acid, 0.5 mass% of quinaldic acid, 0.1 mass% of an acetylene diol-type nonionic surfactant ("Surfynol 485" manufactured by Air Products Japan, Inc., m+n=30 in the formula (1)), and 0.2 mass% of quinaldic acid, an aqueous solution containing the water-soluble polymer (C) (polyacrylic acid P2 prepared in "Preparation of polyacrylic acid aqueous solution") in such an amount that the amount of the polymer was 0.5 mass% was added to the mixture. After the addition of 0.9 mass% of potassium hydroxide and a 35 mass% hydrogen peroxide aqueous solution in such an amount that the amount of hydrogen peroxide was 0.6 mass%, the mixture was stirred for 15 minutes. After the addition of ion-exchanged water so that the total amount of the components was 100 wt%, the mixture was filtered through a filter having a pore diameter of 5 micrometers to obtain a second polishing aqueous dispersion S 1 having a pH of 9.3.

3.4.2. Evaluation of polishing performance of second polishing aqueous dispersion

3.4.2-1. Unpatterned substrate polishing test

A polishing pad made of porous polyurethane ("IC1000" manufactured by Nitta Haas Inc.) was installed in a chemical mechanical polishing system ("EPO-112" manufactured by Ebara Corporation). Each polishing rate measurement substrate given below was chemically and mechanically polished for one minute under the following polishing conditions while supplying the second chemical mechanical polishing aqueous dispersion. The polishing rate was calculated by the following method.

(i) Polishing rate measurement substrate

- A substrate in which a copper film with a thickness of 15,000 angstroms was provided on an 8-inch silicon substrate with a thermal oxide film.
- A substrate in which a tantalum film with a thickness of 2000 angstroms was provided on an 8-inch silicon substrate

with a thermal oxide film.

- A substrate in which a tantalum nitride film with a thickness of 2000 angstroms was provided on an 8-inch silicon substrate with a thermal oxide film.
- A substrate in which a low-dielectric-constant insulating layer ("Black Diamond" manufactured by Applied Materials) with a thickness of 10,000 angstroms was provided on an 8-inch silicon substrate
- A substrate in which a PETEOS film with a thickness of 10,000 angstroms was provided on an 8-inch silicon substrate.

(ii) Polishing conditions

- Head rotational speed: 70 rpm
- Head load: 150 g/cm$^2$
- Table rotational speed: 70 rpm

Second polishing aqueous dispersion supply rate: 200 ml/min

(iii) Calculation of polishing rate

The thicknesses of the copper film, the tantalum film, and the tantalum nitride film were measured after polishing using a resistivity mapping system ("OmniMap RS75" manufactured by KLA-Tencor Corporation), and the polishing rate was calculated from the thickness reduced by chemical mechanical polishing and the polishing time.

The thicknesses of the PETEOS film and the low-dielectric-constant insulating layer were measured after polishing using an optical interference type thickness measurement device ("NanoSpec 6100" manufactured by Nanometrics Japan Ltd.). The polishing rate was calculated from the reduction in thickness due to chemical mechanical polishing and the polishing time.

(iv) Polishing rate

The polishing rate calculation results are shown in Table 3. In Table 3, the polishing rate of each layer is abbreviated as follows.

Polishing rate of copper film: $R_{Cu}$
Polishing rate of tantalum film: $R_{Ta}$
Polishing rate of tantalum nitride film: $R_{TaN}$
Polishing rate of PETEOS film: $R_{In-1}$
Polishing rate of low-dielectric-constant insulating layer ("Black Diamond"): $R_{In-2}$

3.4.2-2. Patterned substrate polishing test

A polishing pad made of porous polyurethane ("IC1000" manufactured by Nitta Haas Inc.) was installed in a chemical mechanical polishing system ("EPO-112" manufactured by Ebara Corporation). Two patterned substrates given below were chemically and mechanically polished in two stages under the following polishing conditions.

(i) Patterned substrate

A patterned substrate (manufactured by ATDF) was used which was produced by depositing a silicon nitride film (thickness: 1000 angstroms) on a silicon substrate, sequentially depositing a low-dielectric-constant insulating layer (Black Diamond film) (thickness: 4500 angstroms) and a PETEOS film (thickness: 500 angstroms) on the silicon nitride film, forming depressions in various patterns, and sequentially depositing a tantalum film (thickness: 250 angstroms), a copper seed film (thickness: 1000 angstroms), and a copper plating film (thickness: 10,000 angstroms).

(ii) Polishing conditions of first polishing step

As a first polishing aqueous dispersion, a mixture obtained by mixing CMS7401, CMS7452 (manufactured by JSR Corporation), ion-exchanged water, and a 4 wt% ammonium persulfate aqueous solution in a weight ratio of 1:1:2:4 was used.

- First polishing aqueous dispersion supply rate: 200 ml/min
- Head rotational speed: 70 rpm
- Head load: 250 g/cm$^2$
- Table rotational speed: 70 rpm
- Polishing time: 2.75 min

(iii) Polishing conditions of second polishing step

- Chemical mechanical polishing aqueous dispersion: second polishing aqueous dispersion prepared in "3.4.1. Preparation of second polishing aqueous dispersion (chemical mechanical polishing aqueous dispersion according to the invention)" Second polishing aqueous dispersion supply rate: 200 ml/min
- Head rotational speed: 70 rpm
- Head load: 150 g/cm$^2$
- Table rotational speed: 70 rpm
- Polishing time: 63 seconds and 111 seconds

The second polishing step was carried out under conditions (1) where the PETEOS film was polished by 300 angstroms (polishing time (A)) after removing the tantalum film, or under conditions (2) where the PETEOS film was completely removed by polishing and polishing was carried out for a further 30 seconds (polishing time (B)).

$$\text{Polishing time (A)} = \{250\ \text{(angstroms)} / \text{polishing rate of tantalum film (angstroms/min)} + 300\ \text{(angstroms)} / \text{polishing rate of PETEOS film (angstroms/sec)} \times 60\ \text{(sec)}\}$$

$$\text{Polishing time (B)} = \{250\ \text{(angstroms)} / \text{polishing rate of tantalum film (angstroms/min)} + 500\ \text{(angstroms)} / \text{polishing rate of PETEOS film (angstroms/sec)} \times 60\ \text{(sec)} + 30\ \text{(sec)}\}$$

The polishing time (A) and the polishing time (B) were polishing times when polishing the patterned substrate calculated based on the polishing rate of the unpatterned substrate. Table 3 shows the results for each case.

It is estimated that, after the second polishing step, the entire conductive barrier layer positioned over the uppermost surface of the PETEOS film was removed when employing the polishing time (A) so that the upper surface of the PETEOS film was exposed. It is estimated that the PETEOS film was also removed when employing the polishing time (B) so that the low-dielectric-constant insulating layer was exposed.

The polished surface of the patterned substrate subjected to the two-stage polishing process was measured for the amount of dishing (angstroms) in the copper interconnect area (line width: 100 micrometers) and the amount of erosion (angstroms) in an area in which a minute interconnect (width of copper interconnect (line)/width of insulating layer (space) = 9 micrometers/1 micrometers) was continuously formed to a dimension of 1000 micrometers using a high-resolution profiler ("HRP240ETCH" manufactured by KLA-Tencor).

The presence or absence of film separation on the polished surface was observed by bright-field illumination using an optical microscope. The presence or absence of scratches in a specific area on the substrate (bonding pad: 750 copper embedded areas (120×120 micrometers) in the diametrical direction of the substrate) was observed by dark-field illumination.

3.5. Examples 2 to 10 and Comparative Examples 1 to 5

Second chemical mechanical polishing aqueous dispersions S2 to S 15 were prepared in the same manner as in Example 1, except for changing the type and the amount of each component of the second chemical mechanical polishing aqueous dispersion as shown in Table 3.

The pH of the second polishing aqueous dispersions S 1 to S9 and S11 to S 13 used in Examples 1 to 9 and

Comparative Examples 1 to 3 was adjusted using potassium hydroxide. The pH of the second polishing aqueous dispersions S 10, S 14, and S15 used in Example 10 and Comparative Examples 4 and 5 was not adjusted.

In Examples 2 to 10 and Comparative Examples 1 to 5, the polishing performance was evaluated in the same manner as in Example 1. In Examples 4 and 8, an alkyl ether-type nonionic surfactant ("Emulgen 147" manufactured by Kao Corporation) was used as the surfactant (F). In Comparative Example 3, the polishing performance was evaluated in the same manner as in Example 1, except for changing the polishing pressure. The results are shown in Table 3.

TABLE 3-1

| | | Example 1 | | Example 2 | | Example 3 | | Example 4 | | Example 5 | | Example 6 | | Example 7 | | Example 8 | | Example 9 | | Example 10 | |
|---|---|---|---|---|---|---|---|---|---|---|---|---|---|---|---|---|---|---|---|---|---|
| | | Aqueous dispersion S1 | | Aqueous dispersion S2 | | Aqueous dispersion S3 | | Aqueous dispersion S4 | | Aqueous dispersion S5 | | Aqueous dispersion S6 | | Aqueous dispersion S7 | | Aqueous dispersion S8 | | Aqueous dispersion S9 | | Aqueous dispersion S10 | |
| | | Type | Amount | Type | Amount | Type | Amount | Type | Amount | Type | Amount | Type | Amount | Type | Amount | Type | Amount | Type | Amount | Type | Amount |
| Organic acid | | Malonic acid | 0.8 | Maleic acid | 1 | Maleic acid | 0.8 | Citric acid | 1 | Maleic acid | 0.8 | Malonic acid | 0.5 | Maleic acid | 0.5 | Malonic acid | 0.3 | Maleic acid | 1 | Maleic acid | 0.3 |
| | | Citric acid | 0.2 | Quinaldic acid | 0.5 | Quinolinic acid | 0.02 | Indole carboxylic acid | 0.5 | Quinolinic acid | 0.02 | Citric acid | 0.5 | Quinaldic acid | 0.5 | Malic acid | 0.2 | Quinaldic acid | 0.2 | Quinolinic acid | 0.05 |
| Water-soluble polymer | | Polyacrylic acid P3 | 2 | Polyacrylic acid P2 | 1 | Polyacrylic acid P1 | 0.2 | Polyacrylic acid P2 | 1 | Polyvinylpyrrolidone | 0.2 | Polyacrylic acid P2 | 0.03 | Polyacrylic acid P1 | 2.5 | Polyacrylic acid P1 | 0.05 | Polyacrylic acid P1 | 0.5 | Polyacrylic acid P1 | 0.3 |
| Surfactant | | Acetylene diol nonionic | 0.5 | Acetylene diol nonionic | 0.01 | Acetylene diol nonionic | 0.1 | Alkyl ether nonionic | 0.5 | Acetylene diol nonionic | 0.1 | Acetylene diol nonionic | 0.01 | Acetylene diol nonionic | 0.01 | Alkyl ether nonionic | 0.5 | - | - | - | - |
| Abrasive grains | | *Colloidal* silica C2 | 3 | *Fumed* silica | 5 | *Colloidal* silica C1 | 5 | Organic-*inorganic* composite particle | 3 | Colloidal silica C3 | 5 | Fumed silica | 3 | Colloidal silica C2 | 4 | Colloidal silica C2 | *10* | Colloidal silica C3 | *1* | Colloidal silica C1 | 5 |
| Oxidizing agent | | Hydrogen peroxide | 0.05 | Hydrogen peroxide | 0.5 | Hydrogen peroxide | 0.2 | Hydrogen peroxide | 0.5 | Hydrogen peroxide | 0.5 | Hydrogen peroxide | 0.2 | Hydrogen peroxide | 0.2 | Hydrogen peroxide | 0.1 | Hydrogen peroxide | 0.2 | Hydrogen peroxide | 0.5 |
| Additive | | | | | | | | | | | | | | | | | | | | BTA | 0.2 |
| pH | | 9.3 | | 10.2 | | 9.5 | | 10.2 | | 10.2 | | 10.8 | | 10.5 | | 9.1 | | 10.6 | | 3.5 | |
| *Unpatterned substrate polishing test* | | | | | | | | | | | | | | | | | | | | | |
| Polishing pressure (gf/cm$^2$) | | 150 | | 150 | | 150 | | 150 | | 150 | | 150 | | 150 | | 150 | | 150 | | 150 | |
| Polishing rate (Å/min) | RCu | 564 | | 592 | | 650 | | 611 | | 525 | | 382 | | 435 | | 663 | | 593 | | 883 | |
| | RTa | 411 | | 440 | | 579 | | 524 | | 610 | | 458 | | 469 | | 745 | | 492 | | 875 | |
| | RTaN | 494 | | 505 | | 650 | | 591 | | 698 | | 550 | | 483 | | 796 | | 510 | | 988 | |
| | RIn-1 | 671 | | 699 | | 747 | | 725 | | 621 | | 468 | | 465 | | 811 | | 501 | | 784 | |
| | RIn-2 | 93 | | 170 | | 114 | | 68 | | 124 | | 172 | | 105 | | 235 | | 396 | | 67 | |
| *Patterned substrate polishing test* | | | | | | | | | | | | | | | | | | | | | |
| Polishing time (A) | | | | | | | | | | | | | | | | | | | | | |
| Patterned substrate polishing time (sec) (when removing 300Å PETEOS film) | | 63 | | 60 | | 50 | | 53 | | 54 | | 71 | | 71 | | 42 | | 66 | | 40 | |
| Flatness | Dishing (Å) L/S=100/100μm | 72 | | 113 | | 68 | | 118 | | 79 | | 175 | | 138 | | 82 | | 120 | | 162 | |
| | Erosion (Å) L/S=9/1 μm | 125 | | 174 | | 133 | | 151 | | 136 | | 135 | | 155 | | 119 | | 92 | | 136 | |
| Defect | Scratch | None | | None | | None | | None | | None | | 1 | | None | | None | | None | | None | |
| | Separation | None | | None | | None | | None | | None | | None | | None | | None | | None | | None | |
| Polishing time (B) | | | | | | | | | | | | | | | | | | | | | |
| Patterned substrate polishing time (sec) (when removing PETEOS film and performing polishing for 30 sec) | | *111* | | *107* | | *96* | | *100* | | *103* | | *127* | | *126* | | 87 | | 120 | | 85 | |
| Flatness | Dishing (Å) L/S=100/100 μm | 83 | | 129 | | 85 | | 135 | | 96 | | 175 | | 138 | | 82 | | 25 | | 146 | |
| | Erosion (Å) L/S=9/1 μm | 139 | | 182 | | 149 | | 161 | | 155 | | 135 | | 155 | | 119 | | 68 | | 125 | |
| *Defect* | Scratch | None | | None | | None | | None | | None | | 2 | | None | | None | | None | | None | |
| | Separation | None | | None | | None | | None | | None | | None | | None | | None | | None | | None | |

TABLE 3-2

| | | Comparative Example 1 | | Comparative Example 2 | | Comparative Example 3 | | Comparative Example 4 | | Comparative Example 5 | |
|---|---|---|---|---|---|---|---|---|---|---|---|
| | | Aqueous dispersion S11 | | Aqueous dispersion S12 | | Aqueous dispersion S13 | | Aqueous dispersion S14 | | Aqueous dispersion S15 | |
| | | Type | Amount | Type | Amount | Type | Amount | Type | Amount | Type | Amount |
| Organic acid | | Malonic acid | 0.8 | Maleic acid | 1 | Maleic acid | 1 | Malonic acid | 0.8 | Malonic acid | 0.8 |
| | | Citric acid | 0.2 | Quinaldic acid | 0.5 | Quinaldic acid | 0.5 | Citric acid | 0.2 | Citric acid | 0.2 |
| Water-soluble polymer | | Polyacrylic acid P4 | 2 | - | - | - | - | Polyacrylic acid P4 | 2 | Polyacrylic acid P4 | 2 |
| Surfactant | | Acetylene diol nonionic | 0.5 | Acetylene diol nonionic | 0.01 | Acetylene diol nonionic | 0.01 | Acetylene diol nonionic | 0.5 | Acetylene diol nonionic | 0.5 |
| Abrasive grains | | Colloidal silica C3 | 3 | Fumed silica | 5 | Fumed silica | 5 | Colloidal silica C3 | 3 | Colloidal silica C3 | 3 |
| Oxidizing agent | | Hydrogen peroxide | 0.05 | Hydrogen peroxide | 0.5 | Hydrogen peroxide | 0.5 | Hydrogen peroxide | 0.05 | Hydrogen peroxide | 0.05 |
| Additive | | | | | | | | | | | |
| pH | | 10.8 | | 10.5 | | 9.2 | | 2.8 | | 12.5 | |
| Unpatterned substrate polishing test | | | | | | | | | | | |
| Polishing pressure (gf/$cm^2$) | | 150 | | 150 | | 350 | | 150 | | 150 | |
| Polishing rate (Å/tufn) | RCu | 323 | | 340 | | 498 | | 823 | | 205 | |
| | RTa | 466 | | 435 | | 510 | | 480 | | 530 | |
| | RTaN | 532 | | 525 | | 581 | | 512 | | 578 | |
| | RIn-1 | 311 | | 290 | | 555 | | 285 | | 410 | |
| | RIn-2 | 85 | | 175 | | 173 | | 52 | | 225 | |
| Patterned substrate polishing test | | | | | | | | | | | |

(continued)

| | | Comparative Example 1 | | Comparative Example 2 | | Comparative Example 3 | | Comparative Example 4 | | Comparative Example 5 | |
|---|---|---|---|---|---|---|---|---|---|---|---|
| | | Aqueous dispersion S11 | | Aqueous dispersion S12 | | Aqueous dispersion S13 | | Aqueous dispersion S14 | | Aqueous dispersion S15 | |
| | | Type | Amount | Type | Amount | Type | Amount | Type | Amount | Type | Amount |
| Polishing time (A) | | | | | | | | | | | |
| Patterned substrate polishing time (sec) (when removing 300Å PETEOS film) | | 90 | | 97 | | 62 | | 94 | | 72 | |
| Flatness | Dishing (Å) L/S=100/100μm | 181 | | 136 | | 115 | | 280 | | -50 | |
| | Erosion (Å) L/S=9/1 μm | 230 | | 160 | | 143 | | 265 | | -20 | |
| Defect | Scratch | 2 | | 12 | | 32 | | None | | 5 | |
| | Separation | None | | None | | Observed | | None | | None | |
| Polishing time (B) | | | | | | | | | | | |
| Patterned substrate polishing time (sec) (when removing PETBOS film and performing polishing for 30 sec) | | 159 | | 168 | | 113 | | 167 | | 131 | |
| Flatness | Dishing (Å) LS=100/100 μm | 176 | | 142 | | 128 | | 215 | | -85 | |
| | Erosion (Å) L/S=9/1 μm | 242 | | 174 | | 165 | | 202 | | -110 | |
| Defect | Scratch | 5 | | 18 | | 47 | | 2 | | 10 | |
| | Separation | None | | Partially observed | | Observed | | None | | None | |

As shown in Table 3, the polishing rate could be significantly increased when chemically and mechanically polishing the insulating layer formed on the semiconductor substrate by using the chemical mechanical polishing aqueous dispersion of each of Examples 1 to 10. Moreover, occurrence of scratches and dishing on the polished surface could be prevented, and a polished surface with excellent flatness could be efficiently obtained.

On the other hand, when using the chemical mechanical polishing aqueous dispersion of each of Comparative Examples 1 to 5, the polishing rate could not be increased. It is considered that the polishing rate decreased due to insufficient viscosity of the chemical mechanical polishing aqueous dispersion because the chemical mechanical polishing aqueous dispersions of Comparative Examples 1, 4, and 5 did not contain a water-soluble polymer having a weight average molecular weight of 50,000 to 5,000,000, and the chemical mechanical polishing aqueous dispersion of Comparative Example 2 did not contain a water-soluble polymer. The chemical mechanical polishing aqueous dispersion of Comparative Example 2 which did not contain a water-soluble polymer caused a larger number of scratches. In Comparative Example 3, since the polishing rate was increased by changing the polishing pressure, a larger number of scratches and film separation occurred. The chemical mechanical polishing aqueous dispersions of Comparative Examples 4 and 5 were the same as the chemical mechanical polishing aqueous dispersion of Comparative Example 1 except for the pH. In Comparative Example 4, the polishing rate of copper was unnecessarily higher than that of the insulating film. In Comparative Example 5, the polishing rate of the insulating film was unnecessarily higher than that of copper. As a result, flatness was impaired as compared with Comparative Example 1.

Since the chemical mechanical polishing aqueous dispersions of Examples 6 and 7 contained the water-soluble polymer (C) in an amount outside the preferable range of 0.05 to 2 mass%, the polishing rate decreased to some extent.

## Claims

1. A chemical mechanical polishing aqueous dispersion comprising (A) abrasive grains, (B) an organic acid, (C) a water-soluble polymer, (D) an oxidizing agent, and (E) water, the water-soluble polymer (C) having a weight average molecular weight of 50,000 to 5,000,000.

2. The chemical mechanical polishing aqueous dispersion according to claim 1, wherein the water-soluble polymer (C) is poly(meth)acrylic acid or its salt.

3. The chemical mechanical polishing aqueous dispersion according to claim 1 or 2,
wherein the chemical mechanical polishing aqueous dispersion contains the water-soluble polymer (C) in an amount of 0.05 to 2 wt%.

4. The chemical mechanical polishing aqueous dispersion according to any one of claims 1 to 3,
wherein the chemical mechanical polishing aqueous dispersion has a pH of 8 to 12.

5. The chemical mechanical polishing aqueous dispersion according to any one of claims 1 to 4,
wherein the organic acid (B) is at least one organic acid selected from the group consisting of quinolinecarboxylic acid, a divalent organic acid, and a hydroxyl acid, and the chemical mechanical polishing aqueous dispersion contains the organic acid (B) in an amount of 0.01 to 5 mass%.

6. The chemical mechanical polishing aqueous dispersion according to any one of claims 1 to 5,
wherein the ratio of the amount of the water-soluble polymer (C) to the amount of the organic acid (B) is 1:40 to 20:1.

7. The chemical mechanical polishing aqueous dispersion according to any one of claims 1 to 6,
the chemical mechanical polishing aqueous dispersion further including (F) a surfactant in an amount of 0.001 to 1 mass%.

8. The chemical mechanical polishing aqueous dispersion according to claim 7,
wherein the ratio of the amount of the water-soluble polymer (C) to the amount of the surfactant (F) is 1:10 to 200:1.

9. The chemical mechanical polishing aqueous dispersion according to claim 7 or 8, wherein the surfactant (F) is a nonionic surfactant.

10. The chemical mechanical polishing aqueous dispersion according to any one of claims 1 to 9,
wherein the chemical mechanical polishing aqueous dispersion contains the abrasive grains (A) in an amount of 1 to 10 mass%.

**11.** The chemical mechanical polishing aqueous dispersion according to any one of claims 1 to 10, wherein the abrasive grains (A) are silica.

**12.** A kit for preparing the chemical mechanical polishing aqueous dispersion according to any one of claims 1 to 11 by mixing a liquid (I) and a liquid (II),
the liquid (I) being an aqueous dispersion including (A) abrasive grains, (B) an organic acid, (C) a water-soluble polymer having a weight average molecular weight of 50,000 to 5,000,000, and (E) water; and
the liquid (II) including (D) an oxidizing agent and (E) water.

**13.** A kit for preparing the chemical mechanical polishing aqueous dispersion according to any one of claims 1 to 11 by mixing a liquid (I) and a liquid (II),
the liquid (I) being an aqueous dispersion including (A) abrasive grains and (E) water; and
the liquid (II) including (B) an organic acid, (C) a water-soluble polymer having a weight average molecular weight of 50,000 to 5,000,000, and (E) water.

**14.** A kit for preparing the chemical mechanical polishing aqueous dispersion according to any one of claims 1 to 11 by mixing a liquid (I), a liquid (II), and a liquid (III),
the liquid (I) being an aqueous dispersion including (A) abrasive grains and (E) water;
the liquid (II) including (B) an organic acid, (C) a water-soluble polymer having a weight average molecular weight of 50,000 to 5,000,000, and (E) water; and
the liquid (III) including (D) an oxidizing agent and (E) water.

**15.** The kit according to claim 13 or 14,
wherein the liquid (I) further comprises one or more components selected from (B) an organic acid, (C) a water-soluble polymer having a weight average molecular weight of 50,000 to 5,000,000, (D) an oxidizing agent, and (F) a surfactant.

**16.** The kit according to any one of claims 13 to 15,
wherein the liquid (II) further comprises one or more components selected from (A) abrasive grains, (D) an oxidizing agent, and (F) a surfactant.

**17.** A chemical mechanical polishing method comprising chemically and mechanically polishing a polishing target at a polishing pressure of 60 to 200 $gf/cm^2$ using the chemical mechanical polishing aqueous dispersion according to any one of claims 1 to 11.

FIG. 1A

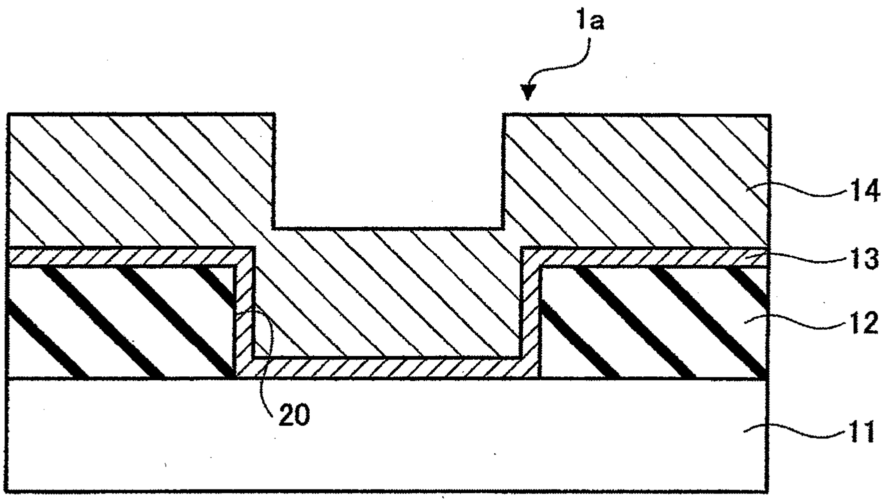


FIG. 1B

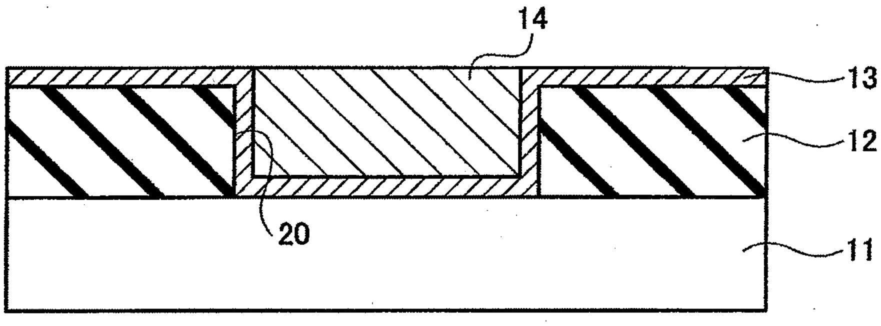


FIG. 1C

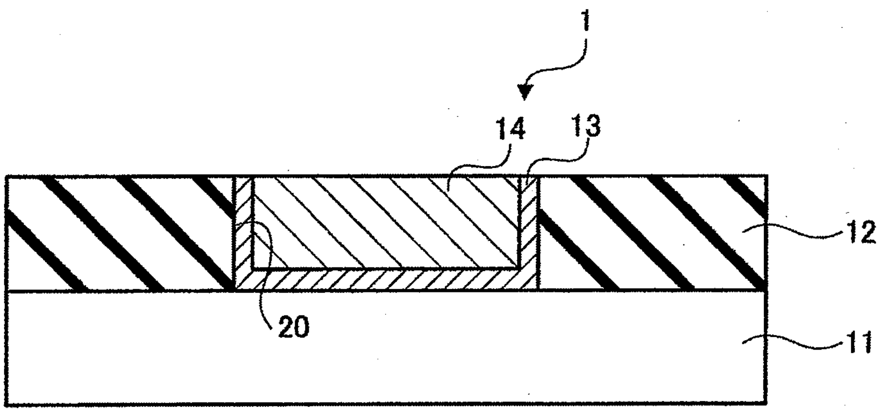

FIG. 2A

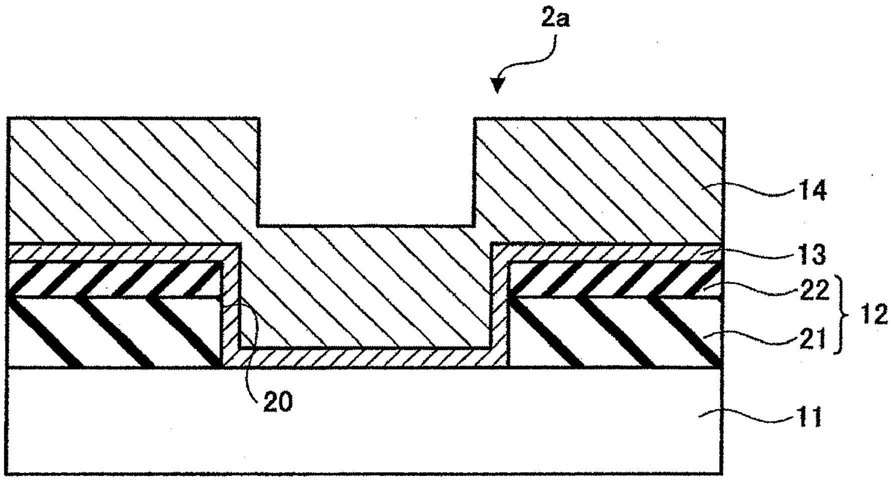


FIG. 2B

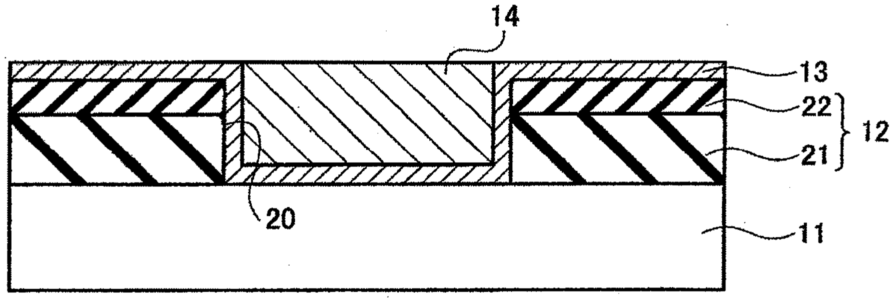


FIG. 2C

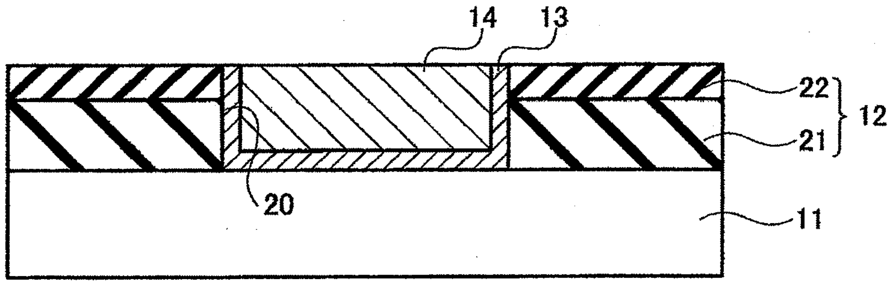


FIG. 2D

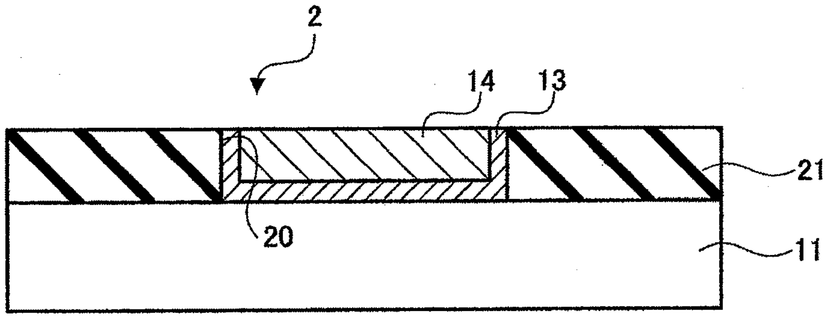

FIG. 3A

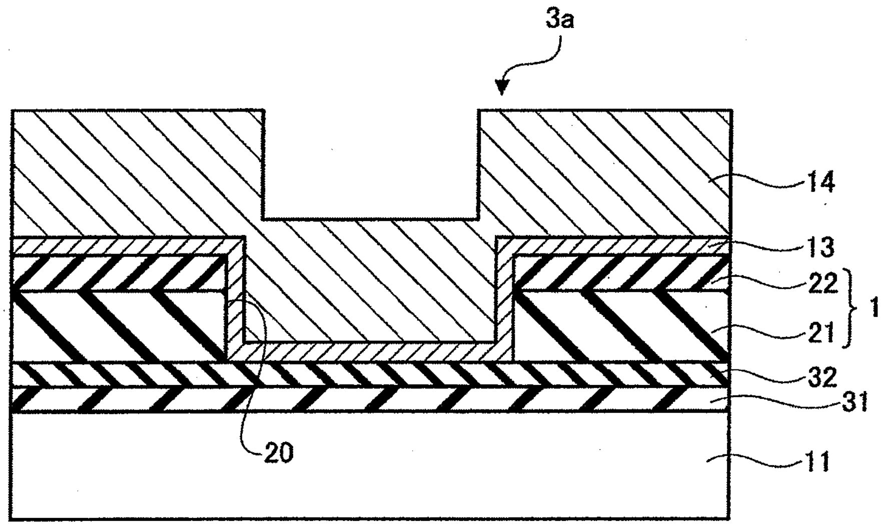


FIG. 3B

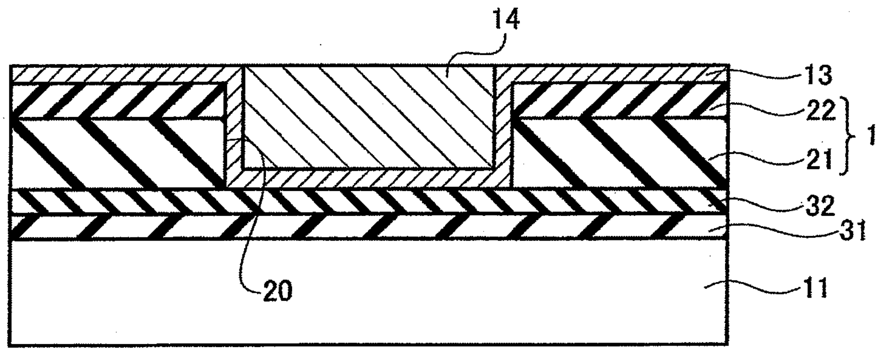


FIG. 3C

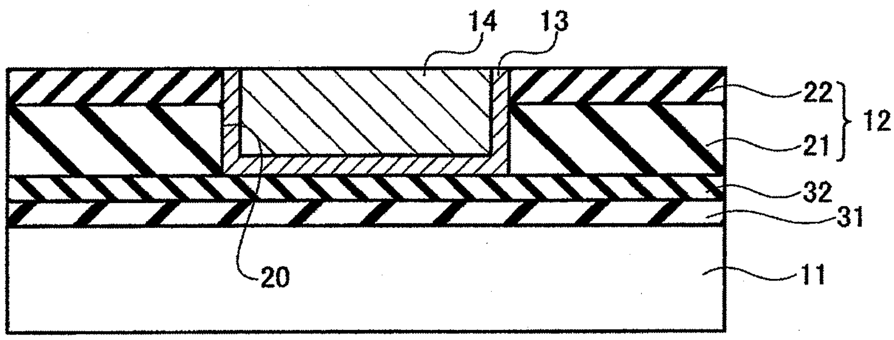


FIG. 3D

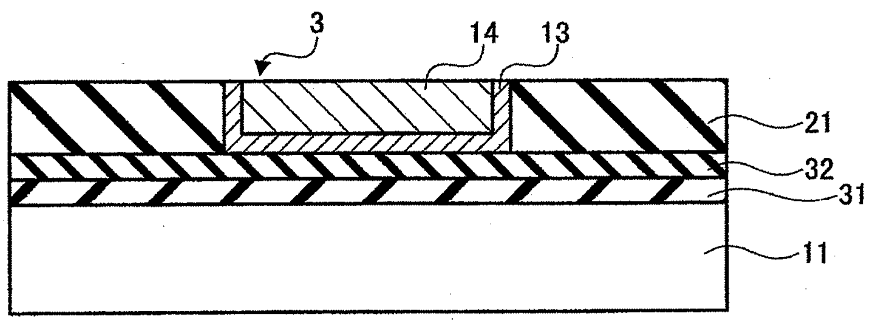

**INTERNATIONAL SEARCH REPORT**

International application No. PCT/JP2007/056501

A. CLASSIFICATION OF SUBJECT MATTER
*H01L21/304*(2006.01)i, *B24B37/00*(2006.01)i, *C09K3/14*(2006.01)i

According to International Patent Classification (IPC) or to both national classification and IPC

B. FIELDS SEARCHED

Minimum documentation searched (classification system followed by classification symbols)
H01L21/304, B24B37/00, C09K3/14

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br><br>Y | JP 2002-164308 A (NEC Corp.), 07 June, 2002 (07.06.02), Par. Nos. [0024] to [0029], [0041] to [0043], [0050] & US 2002/0095872 A1 | 1-2,4-5, 10-16<br>3,6-9,17 |
| Y | JP 2005-217360 A (Hitachi Chemical Co., Ltd.), 11 August, 2005 (11.08.05), Par. Nos. [0018], [0025], [0028]; table 1 (Family: none) | 3,6-9 |
| Y | JP 2005-340755 A (Showa Denko Kabushiki Kaisha), 08 December, 2005 (08.12.05), Par. No. [0083] & WO 2005/047409 A1 & WO 2005/047410 A1 & JP 2005-167231 A | 17 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
23 April, 2007 (23.04.07)

Date of mailing of the international search report
01 May, 2007 (01.05.07)

Name and mailing address of the ISA/
Japanese Patent Office

Authorized officer

Facsimile No.

Telephone No.

Form PCT/ISA/210 (second sheet) (April 2005)

**INTERNATIONAL SEARCH REPORT**

International application No.
PCT/JP2007/056501

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2005-347579 A (Kabushiki Kaisha Nippon Shokubai), 15 December, 2005 (15.12.05), Par. No. [0046] (Family: none) | 17 |
| A | WO 2001/017006 A1 (Hitachi Chemical Co., Ltd.), 08 March, 2001 (08.03.01), Full text & US 2006/0186373 A1 & EP 1223609 A1 | 1-17 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2278822 A
- JP 2001308089 A
- JP 2001298023 A